# EUROPEAN PATENT APPLICATION

(11) **EP 0 980 137 A1**
(43) Date of publication of application: **16.02.2000**
(21) Application number: 99306118.3
(22) Date of filing: 02.08.1999
(51) Int. Cl.: H03F 1/32

(54) **Synchronous pilot detection technique for a control system that reduces distortion produced by electrical circuits**

(30) Priority: 12.08.1998 US 133054
(71) Applicant: LUCENT TECHNOLOGIES INC., Murray Hill, New Jersey 07974-0636 (US)
(72) Inventor: Myer, Robert Evan, Denville, New Jersey 07834 (US)
(74) Representative: Buckley, Christopher Simon Thirsk

(57) **Abstract**

A synchronous pilot detection circuit coupled to a control system which comprises an electrical circuit that produces distortion such that when a pilot signal is applied to the electrical circuit the distortion and any residual distortion is substantially canceled.

## Description

### Background of the Invention

### Field of the Invention

The present invention is directed to a control system that uses a pilot signal to substantially cancel distortion produced by an electrical circuit and more particularly to a synchronous pilot detection circuit coupled to the control system for substantially canceling any residual distortion.

### Description of the Related Art

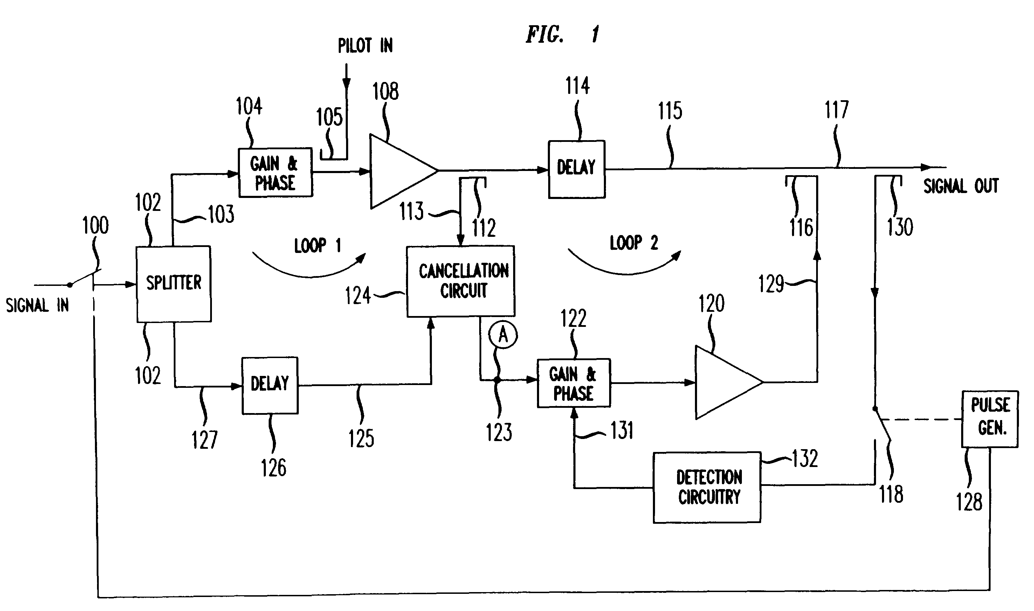

Electrical signals when applied to electrical circuits are often distorted as a result of being processed by the circuits. The distortion comprises any undesired signals which are added to or are somehow combined with the applied signals. A well known technique for substantially canceling distortion produced by electrical circuits uses a control system coupled to the electrical circuit to which a pilot signal is applied. The applied pilot signal, which is predictably distorted by the electrical circuit, is detected by the control system. The applied pilot signal can have a single spectral component (i.e., one frequency) of a certain amplitude or the applied pilot signal can comprise a plurality of spectral components of various amplitudes. The control system obtains information (about the distortion) from the detected pilot signal and uses that information to substantially cancel the distortion produced by the electrical circuit. A control system comprises at least one circuit which uses external signals or signals generated by the at least one circuit to process signals applied to the at least one circuit. A particular implementation of the technique discussed above is shown in FIG. 1.

FIG. 1 depicts a control system, comprising two feed forward loops (loop 1 and loop 2) and detection circuit 132. Coupled to the control system is switching circuitry, comprising switch 100, switch 118 and pulse generator 128), which controls the application of the pilot signal. Electrical circuit 108 can be any electrical and/or electronic (e.g., Radio Frequency (RF) linear amplifier, power amplifier) circuit. Loop 1 comprises coupler 105, Gain & Phase circuit 104, splitter 102 and delay circuit 126. Coupler 105 is typically a device which can combine two or more input signals and allow access to all or a portion of the combined signal. A coupler can also be used to obtain a portion of a signal appearing at its input and output. Gain & Phase circuit 104 is typically a circuit which can modify the amplitude and phase of signals applied to its input based on the values of control signals applied to it control inputs (not shown). Splitter 102 is a circuit with one input and at least two outputs where a signal applied to the input is substantially replicated at the outputs. Delay circuit 126 is typically a circuit which applies a certain amount of delay to a signal applied to its input. Control circuitry (not shown) associated with pulse generator 128 enable and disable switches 110 and 118.

Initially switch 100 is enabled, switch 118 is disabled and an input signal is applied to splitter 102. Splitter 102 substantially replicates the input signal on paths 103 and 127. In path 103 the input signal is applied to Gain & Phase circuit 104, coupler 105 and electrical circuit 108. In path 127, the input signal is delayed by delay circuit 126 and then fed to cancellation circuit 124 via path 125. Although not shown, it will be readily obvious to those skilled in the art that the amplitude and phase of the input signal on path 125 can be detected (using well known detection circuitry) and converted to control signals that are applied to the control inputs (not shown) of Gain and Phase circuit 104. Using coupler 112, a portion of the input signal (plus any distortion produced by electrical circuit 108) appearing at the output of electrical circuit 108 is fed to cancellation circuit 124 via path 113. Cancellation circuit 124 can be implemented as a combiner circuit which has at least two inputs and one output; such a circuit combines signals applied to its inputs and transfers the combined signal to its output. Gain and Phase circuit 104 is adjusted such that the amplitude and phase of the input signal on path 113 are modified resulting in that signal being substantially 180° out of phase (i.e., substantially the inverse) with the input signal on path 125 such that when the two signals are combined by cancellation circuit 124 they substantially cancel each other leaving the distortion (produced by electrical circuit 108) at point A (path 123). Thus Loop 1 is designed to isolate the distortion produced by electrical circuit 108.

Loop 2, which comprises delay circuit 114, coupler 116, Gain & Phase circuit 122, and amplifier 120, is designed to obtain information from the output signal (i.e., output of electrical circuit 108) to substantially cancel the distortion produced by electrical circuit 108. In particular, pulse generator 128 generates a pulse of a certain duration during which switch 100 is disabled, switch 118 is enabled and a pilot signal is applied to electrical circuit 108 via coupler 105. Because switch 100 is disabled during the time the pilot signal is applied to electrical circuit 108, there is virtually no chance of the pilot signal interfering with the input signal. The pilot signal (processed by electrical circuit 108) appears on path 115 and at the output of coupler 116, i.e., on path 117. The pilot signal also appears at point A on path 123 after having propagated on path 113 via coupler 112. A portion of the processed pilot signal processed by electrical circuit 108 is fed to detection circuit 132 via coupler 130. Detection circuit 132 comprises well known circuits (e.g., Log detector/amplifier, Sample & Hold circuit, Null circuit) to detect signal characteristics (e.g., amplitude, spectral content, phase response) of the pilot signal. Some or all of the characteristics may have been altered due to the distortion effects of electrical circuit 108. Detection circuit 132 detects the amplitude distorted characteristics of the input and uses this information to generate control signals on path 131 to cause Gain & Phase circuit 122 to modify the pilot signal. appearing at point A. The pilot signal at point A is modified such that the pilot signal appearing on path 129 is substantially the inverse (relatively same amplitude, 180° out of phase, +/- 10° or less) of the pilot signal appearing on path 115. Amplifier 120 provides additional gain to the output of Gain & Phase circuit 122. The additional gain is calculated such that the signal appearing on path 129 has an amplitude substantially equal to the amplitude of the signal on path 115. Delay circuit 114 is designed such that the two pilot signals arrive at coupler 116 at substantially the same moment; that is, the two pilot signals are substantially synchronized (aligned in time) to each other. When the two pilot signals are combined by coupler 116 they cancel each other.

Once the duration of the pulse generated by pulse generator 128 has lapsed, switch 110 is enabled, switch 118 is disabled and the pilot signal is no longer applied to electrical circuit 108. The input signal is again applied to electrical circuit 108. Any distortion produced by electrical circuit 108 is isolated at point A ( on path 123) as discussed above. The signal on path 115 is the input signal (processed by electrical circuit 108) plus any distortion produced by electrical circuit 108. The distortion at point A is modified by Gain and Phase circuit 122 based on the information (i.e., signal characteristics) obtained from the previously applied pilot signal so that the distortion on path 129 is substantially the inverse of the distortion on path 115. The distortions on path 115 and path 129 are combined at coupler 116 causing the distortions to substantially cancel each other resulting in an output signal that is substantially free of distortion.

However, there is rarely an absolute cancellation of the distortion. The output of the control system of FIG. 1 still contains some relatively minute amount of distortion and a substantially attenuated pilot signal. Part of the residual distortion is due to amplifier 120 of loop 2 which also produces distortion. Also, the distortion produced by electrical circuits, such as electrical circuit 108 and amplifier 120, is dynamic in nature requiring that new adjustments be made to Gain & Phase circuit 122. The new adjustments are made from additional applications of the pilot signal to obtain information that is used to cancel the distortion. Each application of the pilot signal involves activating switches 100 and 118 to switch in and switch out the input signal and the pilot signal. As is well known in the art to which this invention belongs, the switching in and switching out of signals creates spurious signals whose frequency content is equal to or is an integer multiple of the rate of switching. The spurious signals occur during the act of switching and thus cannot be canceled by the control system. The frequency content of the spurious signals often are located within the bandwidth of operation of electrical circuit 108., and thus such signals may interfere with the applied pilot signal on the input signal.

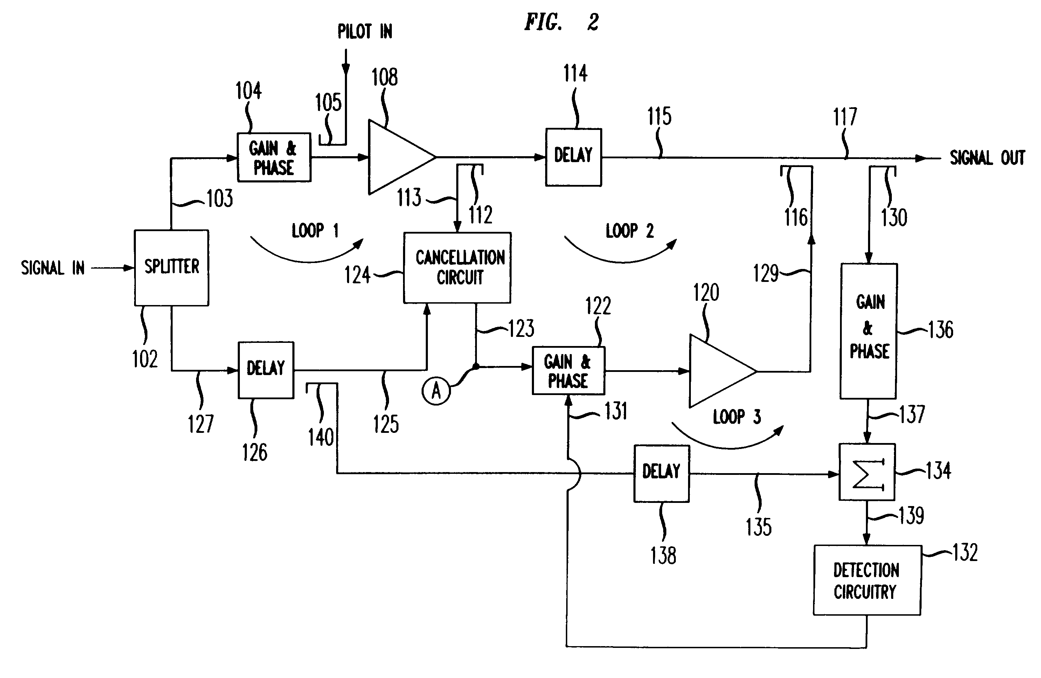

FIG. 2 depicts another implementation in which a pilot signal is applied to an electrical circuit that produces distortion and which electrical circuit is part of a control system that uses information obtained from the applied pilot signal to substantially cancel the distortion. The control system comprises two feed forward loops (Loop 1, Loop 2) where Loop 1 isolates distortion produced by electrical circuit 108 at point A. Loop 2 uses information obtained from the applied pilot signal to substantially cancel the distortion and the applied pilot signal. Any residual distortion not canceled by Loop 2 is substantially canceled with the use of a third feed forward loop, i.e., Loop 3.

Loop 3, which comprises coupler 140, delay circuit 138, summer 134, Gain & Phase circuit 136 and coupler 130, is able to detect the pilot signal--albeit substantially attenuated--at the output of the control system. Summer 134 is a circuit having at least two inputs and one output and algebraically adds the amplitude and phase or power of its input signals. A portion of the signal ( residual distortion + input signal + pilot signal) at the output ofthe control system is obtained via coupler 130 and applied to Gain & Phase circuit 136 whose output is applied to an input of summer 134 via path 137. Detection circuitry (not shown) detect the output of the control system and generate control signals applied to control inputs (not shown) of Gain & Phase circuit 136 causing the phase and amplitude of the output signal to be modified (i.e., inverted). A portion of the delayed input signal on path 125 is obtained via coupler 140 and applied to delay circuit 138 whose output is applied to another input of summer 134 via path 135. The signals on path 137 (-input signal - residual distortion - pilot signal) and path 135 (+input signal) appear at the respective inputs of summer 134 at substantially the same moment and are added algebraically to each other resulting in the input signals canceling each other leaving only the pilot signal and the residual distortion on path 139 which are fed to detect circuit 132.

Information about certain characteristics (e.g., amplitude, spectral content, phase response) of the detected pilot signal and residual distortion is obtained by detection circuit 132 and converted to control signals which are applied to Gain & Phase circuit 122. Gain & Phase circuit 122 modifies the distortion and pilot signal at point A; the modified distortion and pilot signal appear on path 129. The output of electrical circuit 108 comprising the input signal, the pilot signal and distortion is delayed by delay circuit 114 and appear on path 115. The signals on path 115 and path 129 are combined by coupler 116 so that the pilot signal and the distortion--including any residual distortion-- are substantially canceled leaving the input signal at the output of the control system. The pilot signal is applied continuously allowing Gain & Phase circuit 122 to make the proper adjustments to cancel the distortion and any residual distortion appearing at the output of the control system.

It is desirable that the pilot signal be spectrally located substantially in the middle of the frequency band of operation of electrical circuit 108 because the distortion experienced by such a pilot signal tends to be substantially similar to the distortion experienced by an input signal applied to electrical circuit 108. However, placing the pilot signal anywhere in the band of operation of electrical circuit 108 causes interference to occur between the input signal and the pilot signal adding more distortion to the input signal. The interference is any interaction between the pilot signal and an applied input signal that adversely affects one or more characteristic (e.g., amplitude, frequency, phase) of the applied input signal or the pilot signal. To address this interference problem, the pilot signal applied to electrical circuit 108 of FIG. 2 is made to have an amplitude that is much less (typically 30 dB lower) than the amplitude of the input signal. However, when the amplitude of the pilot signal is reduced, the pilot signal becomes susceptible to distortions to the extent that its characteristics (e.g., amplitude, phase, frequency content) are significantly adversely affected making such a pilot signal difficult to detect.

Although the use of a third feed forward loop (i.e., Loop 3 of FIG. 2) addresses the residual distortion, it does not adequately address the interference that typically occurs between the pilot signal and the input signal. On the other hand, there is virtually no interference between the pilot signal and any input signal when switching circuitry is used to apply the pilot signal as shown in FIG. 1. However, the use of such switching circuitry creates undesirable spurious signals that cannot be canceled by the control system. Moreover, both of the techniques discussed above involve additional circuitry that is coupled to the control system and which significantly increase the size, cost and complexity of the control system.

There is therefore a need for a control system that --without creating spurious signals--substantially eliminates the distortion, including residual distortion, created by an electrical circuit coupled to such a control system. The distortion is substantially eliminated when the distorted characteristics (e.g., amplitude, spectral content, phase response) are attenuated to such an extent that they can hardly be detected by the detection circuit. There is also a need for a control system that substantially cancels any interference between an applied pilot signal and any signal produced by or applied to the control system. There is a further need to use a technique that does not significantly increase the size, cost and complexity of the control system.

### Summary of the Invention

The present invention is a control system comprising an electrical circuit that produces distortion and additional circuitry coupled to the control system which circuitry does not create spurious signals and does not significantly add to the cost and complexity ofthe control system.

In particular, the present invention provides a synchronous pilot detection circuit coupled to the control system to which a pilot signal is applied where information obtained from the pilot signal is used to cancel substantially the distortion including any residual distortion and where the synchronous pilot detection circuit substantially cancels any interference between the applied pilot signal and any other signal applied to or produced by the electrical circuit. The random characteristics of the interference between the applied pilot and the applied signal allows averaging to be used to substantially cancel the interference.

### Brief Description of the Drawings

FIG. 1 depicts a prior art control system for substantially canceling distortion produced by an electrical circuit with the use of switching circuitry;
FIG. 2 depicts a prior art control system for substantially canceling distortion produced by an electrical circuit with the use of a third feedforward loop;
FIG. 3 depicts the control system of the present invention;
FIG. 4 shows a particular implementation of a synchronous pilot detection circuit.

### Detailed Description

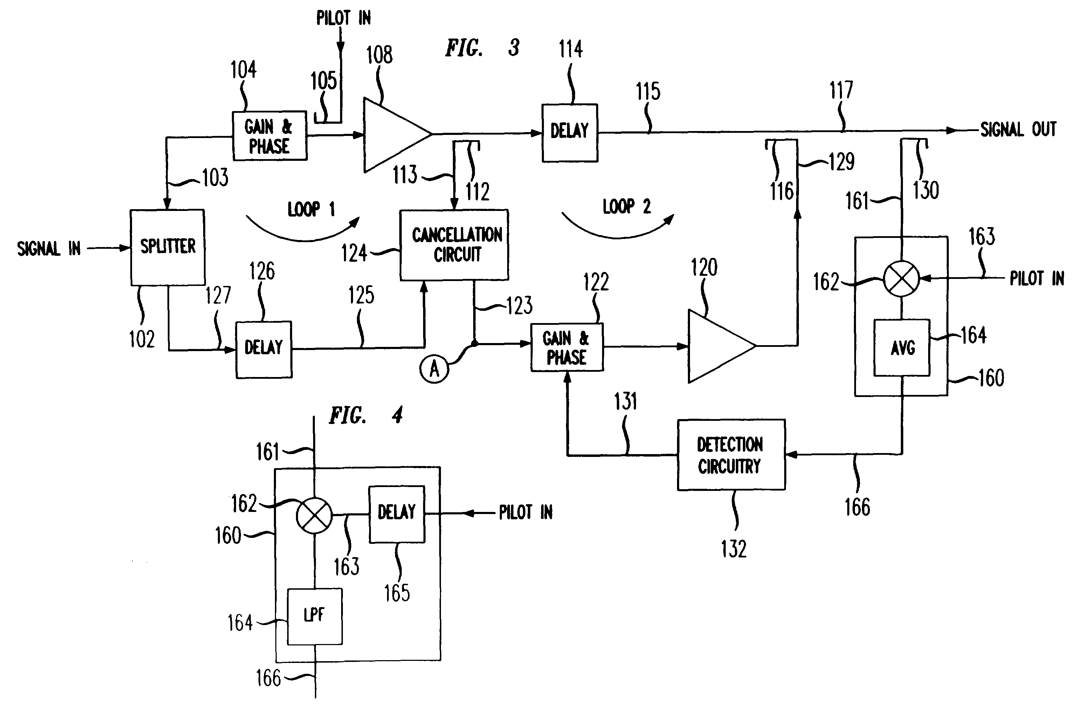

Referring to FIG. 3, there is shown a control system comprising electrical circuit 108, loop 1 and loop 2 and detection circuit 132. A pilot signal is applied to electrical circuit 108 via coupler 105. An input signal is applied to the input of the control system via splitter 102. Synchronous pilot detection circuit 160 is coupled (via coupler 130 and path 166) to the control system for detecting the applied pilot signal and for obtaining information from the applied pilot signal that is used to cancel substantially distortion, including any residual distortion, produced by electrical circuit 108. Also, synchronous pilot detection circuit 160 substantially cancels any interference between the pilot signal and the input signal or any other signal applied to or produced by electrical circuit 108. Substantial cancellation occurs when the output of averaging circuit 160 outputs a pilot signal with relatively the same characteristics as the pilot signal on path 163.

Synchronous pilot detection circuit 160 comprises mixer 162 coupled to averaging circuit 164. Averaging circuit 164 calculates an average of the distortion affecting the pilot signal for a period of time. The period of time during which the averaging is done depends on the frequency content of the pilot signal. For example, a sufficient the period of time is calculated to be at least one period of the pilot signal where the period is the reciprocal of the pilot bandwidth; that is, if the pilot signal has a bandwidth of 500Hz, one period equals 1/500 or 2 milliseconds. The distortion produced by electrical circuit 108 is statistically random in nature and thus the pilot signal characteristics (e.g., amplitude, phase ) will be distorted randomly. Further, any signal applied to or produced by electrical circuit 108 is uncorrelated to the pilot signal and will interfere randomly with the pilot signal. It is well known that taking the average of a statistically random characteristic of a signal over a sufficient period of time is zero or nearly zero. Therefore, when the pilot signal is applied to averaging circuit 164, any interference between the pilot signal and the input signal or any other signal applied to or produced by electrical circuit 108 is substantially canceled.

Loop 1, loop 2 and detection circuit 132 operate in substantially the same fashion as described earlier in conjunction with FIGS. 1 and 2. in the prior art. An input signal is applied at the input of the control system and a pilot signal is applied at the input of electrical circuit 108 via coupler 105. The pilot signal applied to electrical circuit 108 appears, albeit attenuated, on path 117 along with any distortion produced by electrical circuit 108. In addition to the distortion and the attenuated pilot signal, any interference between the applied pilot signal and the input signal also appears on path 117. The signal on path 117 is coupled to path 161 via coupler 130. The pilot signal is also applied to path 163. Thus, the signals on paths 161 and 163 are mixed and the result is applied to averaging circuit 164. The pilot signals from the pilot generator (not shown) is mixed with the signal from electrical circuit 108 which includes the pilot signal. are thus mixed with each other.

The mixing of a particular signal with itself similar to the manner that the pilot signals on paths 163 and 161 are mixed with each other is one particular illustration of synchronous detection. Synchronous detection separates the particular signal from other signals facilitating the detection of the particular signal. The result of the synchronous detection is that the pilot signal is separated from any input signal applied to or produced by electrical circuit 108. The separated pilot signal, which may still be affected by interference with any other signal applied to or produced by electrical circuit 108, is applied to averaging circuit 164. Averaging circuit 164 substantially cancels any existing interference and feeds the pilot signal to detection circuitry 132 via path 166. Based on the information obtained from the detected pilot signal on path 161, detection circuit 132 generates control signals on path 131 which cause Gain & Phase circuit 122 to modify the distortion appearing at point A such that the distortion and any residual distortion are canceled substantially at coupler 117.

FIG. 4 shows a particular implementation of synchronous pilot detection circuit 160. The pilot signal on path 163 is delayed by delay circuit 165 to control the moment at which the pilot signals on paths 163 and 161 are mixed with each other. Averaging circuit 164 is implemented as a Low Pass Filter.

## Claims

1. A control system comprising an electrical circuit (108) that produces distortion where a pilot signal is applied to the electrical circuit and the pilot signal is used by the control system to substantially cancel the distortion, the control system further comprising:
a synchronous pilot detection circuit (160) coupled to the control system allowing the control system to obtain information from the applied pilot signal that the control system uses to substantially cancel any residual distortion and the synchronous pilot detection circuit substantially cancels any interference between the applied pilot and any other signal applied to or produced by the electrical circuit.

2. The control system of claim 1 where the synchronous pilot detection circuit comprises a mixer (162) coupled to an averaging circuit (164) where the averaging circuit substantially cancels any interference between the applied pilot signal and any other signal.

3. The control system of claim 2 where the averaging circuit is a Low Pass Filter.

4. The control system of claim 2 where the mixer has an input that is coupled to a delay circuit (165).

5. The control system of claim 1 where the pilot signal has a single spectral component.

6. The control system of claim 1 where the pilot signal is applied for a period of time equal to at least the reciprocal of its bandwidth.

7. The control system of claim 1 further comprising a first feed forward loop (LOOP 1), a second feed forward loop (LOOP 2) coupled to the first feed forward loop and a detection circuit (132) coupled to the second feed forward loop.

8. The control system of claim 1 where synchronous pilot detection circuit is further coupled to detection circuitry that obtain the information from the detected pilot signal and convert the information to control signals that are transferred to the control system to cancel substantially any residual distortion.

9. A method for canceling distortion produced by an electrical circuit that is part of a control system having an input and an output where the control system uses information obtained from an applied pilot signal to cancel the distortion, the method comprising the steps of:
applying the pilot signal to the electrical circuit and a signal to the input of the control system;
detecting synchronously the applied pilot signal at the output of the control system;
applying the synchronously detected pilot signal to an averaging circuit to substantially cancel any interference between the pilot signal and any other signal applied to or produced by the electrical circuit; and
obtaining information from the synchronously detected pilot signal to cancel any residual distortion.

10. The method of claim 9 wherein the step of applying the synchronously detected pilot signal comprises the steps of mixing the pilot signal with itself.

11. The method of claim 9 wherein the step of obtaining the additional information comprises the steps of applying the synchronously detected pilot signal to detection circuitry and converting the additional information to control signals applied to the control system for canceling distortion including any residual distortion.
